# EUROPEAN PATENT APPLICATION

(11) **EP 1 693 142 A1**
(43) Date of publication of application: **23.08.2006**
(21) Application number: 06250778.5
(22) Date of filing: 14.02.2006
(51) Int. Cl.: B23K 35/00

(54) **Lead-free solder paste**

(30) Priority: 15.02.2005 US 58126
(71) Applicant: Qualitek International, Inc., Addison, IL 60101 (US)
(72) Inventor: Wicker, Tippy, St. Charles, Illinois 60174 (US); Han, Phodi, St. Charles, Illinois 60174 (US)
(74) Representative: Lunt, Mark George Francis

(57) **Abstract**

A lead-free solder paste suitable for soldering components in electronic or microelectronic circuitry including a solder powder and a flux medium. The flux medium includes at least one colored dye material and at least one fluorescent dye material. The solder paste upon melting undergoes a color change from a colored state to a colorless metallic state and the melted solder paste fluoresces under black light.

## Description

### FIELD OF THE INVENTION

This invention relates to a lead-free solder paste suitable for soldering components in electronic and microelectronic circuitry; in particular, to a colored lead-free solder paste which upon melting reverts to a colorless metallic state and fluoresces under black light.

### BACKGROUND OF THE INVENTION

Solder pastes generally include low-melting temperature conducting alloys or solder powders and a flux medium. Such solder pastes may be used to join electrical or electronic components by wetting the component surfaces with melted solder powder and then solidifying the solder powders to a mechanically strong solid solder joint. Solder powders suitable for use in electronic applications should be strong and creep and corrosion-resistant and should be reasonable electrical conductors. One such solder paste or cream is disclosed, for example, in U.S. Patent 4,373,974 to Barajas which is hereby incorporated by reference.

Traditionally, lead-tin solders have been used for electrical applications due to desirable characteristic such as, for example, good mechanical properties combined with high wettability. However, lead-tin solders or other lead containing solders have in recent years been replaced with lead-free formulations due to increased environmental and legislative pressures in the U.S. and abroad.

In practice, however, lead-containing solder pastes and lead-free solder pastes are nearly indistinguishable from each other upon visual inspection. Both types of solder pastes generally have the same coloration before and after soldering. Thus, visual inspection is an unreliable method for determining whether a lead-containing solder paste versus a lead-free solder paste is being used or has been used for a particular soldering process. Additionally, it is virtually impossible to visually determine if a lead-free solder paste has been mixed or contaminated with a lead-containing solder material. Such mixing or contamination of a lead-free solder paste with a lead-containing material may lead to an increased likelihood of failure of a soldered product during final assembly of an associated electronic assembly.

Various soldering pastes and creams containing dye materials have been disclosed in the art to aid in the inspection of finished work products. Such materials include a colored dye material which leaves a colored residue on the soldered components such as, for example, a colored membrane as disclosed in U.S. Patent 5,650,020. However, such colored membrane may interfere with subsequent soldering operations and/or may detract from the appearance of the finished product. Other soldering compositions may include fluorescent dyes which may be illuminated using black light to inspect the quality of a solder joint such as disclosed in U.S. Patent 4,670,298, for example. However, such materials generally do not have a visible coloration.

In view of the above, there is a need and a demand for a lead-free solder paste that can be visually distinguished from a lead-containing soldering product using the naked eye. In particular, there is a need and a demand for a colored lead-free solder paste which when melted loses its color and reverts to a metallic coloration. There is a further need and demand for a colored lead-free solder paste which upon melting fluoresces.

### SUMMARY OF THE INVENTION

A feature and advantage of the invention is to provide an improved lead-free solder paste.

A more specific feature and advantage of the invention is to overcome one or more of the problems described above.

The features and advantages of the invention can be attained, at least in part, through a lead-free solder paste including a solder powder and a flux medium, the flux medium including a least one colored dye material and at least one fluorescent dye material. Upon melting, the solder paste undergoes a color change from a colored state to a colorless metallic state. The melted solder paste fluoresces under black light.

The invention is also directed to a lead-free solder paste including:
about 80 to about 95 composition weight percent of a solder powder including at least two metallic components;
about 5 to about 20 composition weight percent of a flux medium including a rosin tackifying material, at least one organic acid, a rheological modifier, at least one colored dye material, and at least one fluorescent dye material;
wherein upon melting the solder paste undergoes a color change from a colored state to a colorless metallic state and the melted solder paste fluoresces under black light.

The invention is also directed to a lead-free solder paste including:
about 86 to about 91 composition weight percent of a solder powder including tin, silver and copper;
about 9 to about 14 composition weight percent of a flux medium, the flux medium including:
   about 45 to about 50 weight percent hydrogenated rosin;
   about 0.5 to about 15 weight percent organic acid;
   about 2 to about 6 weight percent rheological modifier;
   about 1 to about 15 weight percent surfactant;
   about 0.2 to about 4.0 weight percent of at least one colored dye material; and
   about 0.01 to about 4.0 weight percent of at least one fluorescent dye material;
   wherein upon melting the solder paste undergoes a color change from a colored state to a colorless metallic state and the melted solder fluoresces under black light.

References herein to the term "black light' is to be understood to refer to ultraviolet radiation in the range of about 200 nm to about 400 nm.

Other features and advantages will be apparent to those skilled in the art from the following detailed description taken in conjunction with the appended claims.

Throughout the description and claims of this specification, the words "comprise" and "contain" and variations of the words, for example "comprising" and "comprises", means "including but not limited to", and is not intended to (and does not) exclude other moieties, additives, components, integers or steps.

Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith.

### DETAILED DESCRIPTION OF PREFERRED EMBODIMENTS

The present invention provides a colored lead-free solder paste suitable for soldering components in electronic and microelectronic circuitry. The lead-free solder paste includes a solder powder and a flux medium. The lead-free solder paste may include at least about 80 composition weight percent solder powder; suitably, about 80 to about 95 composition weight percent; and suitably, about 86 to about 91 composition weight percent solder powder. The lead free solder paste may include at least about 5 composition weight percent flux medium; suitably, about 5 to about 20 composition weight percent flux medium; and suitably, about 9 to about 14 composition weight percent flux medium.

The solder powder includes at least one metallic component selected from tin, bismuth, gold, germanium, silver, gallium, antimony, indium, zinc, copper, phosphorous, silicon and combinations thereof. Generally, such solder powders may have a particle size of about 10 to about 100 microns and, suitably, about 25 to about 45 microns. Suitably, the solder powder may include at least about 85 weight percent tin; suitably, about 85 to about 100 weight percent tin; and suitably, about 95 to about 97 weight percent tin.

The solder powder may include at least two metallic components selected from tin, bismuth, gold, germanium, silver, gallium, antimony, indium, zinc, copper, phosphorous, silicon and combinations thereof. Suitably, the solder powder may include a mixture of tin, silver and copper. One suitable solder powder may include at least about 85 weight percent tin, at least about 0.1 weight percent silver, and at least about 0.3 weight percent copper; suitably, about 85 to about 99 weight percent tin, about 2 to about 6 weight percent silver, and about 0.1 to about 2 weight percent copper; and suitably, about 95 to about 97 weight percent tin, about 2 to about 5 weight percent silver, and about 0.3 to about 1 weight percent copper.

The flux medium may include at least one colored dye material. Suitable colored dye materials provide a consistent coloration to the solder paste which is readily visible to naked eye and does not interfere with the soldering processes and/or subsequent product inspection. The colored dye material may be one of a variety of colors.

Suitable colored dye materials for use in the present invention thermally degrade and/or lose color at a temperature which falls within the melt temperature range of the solder paste. It is believed that the solder paste, upon melting, changes from a colored state to a colorless metallic state due to thermal degradation of the colored dye material. Solder pastes in accordance with the present invention may have a melt temperature range of about 140°C to about 260°C, suitably about 180°C to about 230°C, and suitably about 200°C to about 220°C.

The flux medium may include at least one colored dye material in a concentration of at least about 0.2 weight percent. Suitably, the flux medium includes about 0.2 to about 4 weight percent of at least one colored dye material. Suitably, the flux medium includes about 0.5 to about 2 weight percent of at least one colored dye material.

Suitable flux mediums also include at least one fluorescent dye material. Suitable fluorescent dye materials cause the solder paste upon melting to fluoresce under black light. Suitable fluorescent dye materials are thermally stable within the melt temperature range of the solder paste and do not significantly degrade during storage of the unused solder paste.

The flux medium may include at least about 0.01 weight percent of at least one fluorescent dye material. Suitably, the flux medium includes at least about 0.01 to about 4 weight percent of at least one fluorescent dye material. Suitably, the flux medium includes about 0.01 to about 2 weight percent fluorescent dye material.

The flux medium may also include a tackifying material such as, for example, a rosin material. The rosin material may be a hydrogenated rosin. The rosin material may be a synthetic or natural material. The flux medium may include at least about 20 weight percent tackifying material. Suitably, the flux medium may include about 30 to about 60 weight percent tackifying material. Suitably, the flux medium may include about 45 to about 50 weight percent tackifying material.

The flux medium may also include at least one organic acid such as, for example a fatty acid, a carboxylic acid or a combination thereof. Examples of suitable fatty acids include stearic acid, lauric acid, palmitic acid and combinations thereof. Suitable carboxylic acids include succinic acid, glutaric acid, adipic acid, suberic acid and combinations thereof. The flux medium may include at least about 0.5 weight percent organic acid. Suitably, the flux medium may include about 0.5 to about 15 weight percent organic acid. Suitably, the flux medium may include about 1 to about 10 weight percent organic acid.

The flux medium may further include a rheological modifier or thickener. Such rheological modifiers generally increase the viscosity of the flux medium and may function as a suspension medium to prevent settling of the solder powder particles in the solder paste. Suitable rheological modifiers include materials which do not leave a residue of insoluble inorganic material on the solder metal after soldering such as, for example, castor wax. The flux medium may include at least about 1 weight percent rheological modifier. Suitably, the flux medium may include about 2 to about 6 weight percent rheological modifier. Suitably the flux medium may include about 3 to about 5 weight percent rheological modifier. Suitably, the flux medium may include about 3 to about 5 weight percent castor wax rheological modifier.

The flux medium may include a surfactant or surface active agent. Suitable surfactants include ethoxylated amines, alkanolamines, ethoxylated alcohols and combinations thereof. The flux medium may include at least about 1 weight percent surfactant. Suitably, the flux medium may include about 1 to about 30 weight percent surfactant. Suitably, the flux medium may include about 1 to about 15 weight percent surfactant. Suitably, the flux medium may include about 1 to about 3 weight percent of an alkanolamine surfactant such as, for example, triethanolamine.

The flux medium may also include a plasticizer such as, for example, castor oil, rosin esters, fatty acid esters and mixtures of fatty acid esters, and combinations thereof. The plasticizer may be a synthetic or a naturally derived material. The flux medium may include at least about 1 weight percent plasticizer. Suitably, the flux medium may include about 1 to about 30 weight percent plasticizer. Suitably, the flux medium may include about 1 to about 15 weight percent plasticizer.

The flux medium may include at least about 5 weight percent solvent and, suitably, about 10 to about 60 weight percent solvent. A suitable solvent for use in the present invention is glycol ether. The flux medium may include about 10 to about 60 weight percent glycol ether.

A lead-free solder paste may be produced by: preparing a flux medium including at least one colored dye material and at least one fluorescent dye material; preparing a solder powder including at least one metallic component; and dispersing the solder powder in the flux medium.

While in the foregoing detailed description this invention has been described in relation to certain embodiments, and many details have been set forth for the purposes of illustration, it will be apparent to those skilled in the art that the invention has additional embodiments and that certain details described herein can be varied without departing from the basic principles of the invention.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of any foregoing embodiments. The invention extends to any novel one, or any novel combination, of the features disclosed in this specification (including any accompanying claims, abstract and drawings), or to any novel one, or any novel combination, of the steps of any method or process so disclosed.

## Claims

1. A lead-free solder paste comprising:
a solder powder; and
a flux medium including at least one colored dye material and at least one fluorescent dye material;
wherein upon melting the solder paste undergoes a color change from a colored state to a colorless metallic state and the melted solder paste fluoresces under black light.

2. The lead-free solder paste of Claim 1, wherein the solder paste comprises at least about 80 composition weight percent solder powder.

3. The lead-free solder paste of Claim 1 or 2, wherein the solder powder has a particle size of about 25 to about 45 microns.

4. The lead-free solder paste of Claim 1, 2 or 3, wherein the solder powder comprises at least one metallic component selected from the group consisting of tin, bismuth, gold, germanium, silver, gallium, antimony, indium, zinc, copper, phosphorous, silicon and combinations thereof.

5. The lead-free solder paste of any preceding claim, wherein the solder paste comprises at least about 5 composition weight percent flux medium.

6. The lead-free solder paste of any preceding claim, wherein the flux medium comprises at least about 0.2 weight percent of at least one colored dye material.

7. The lead-free solder paste of any preceding claim, wherein the flux medium comprises at least about 0.01 weight percent of at least one fluorescent dye material.

8. The lead-free solder paste of any preceding claim, wherein the flux medium further comprises a tackifying material.

9. The lead-free solder paste of any preceding claim, wherein the flux medium further comprises a rheological modifier.

10. A lead-free solder paste comprising:
about 80 to about 95 composition weight percent of a solder powder including at least two metallic components;
about 5 to about 20 composition weight percent of a flux medium including a rosin tackifying material, at least one organic acid, a rheological modifier, at least one colored dye material and at least one fluorescent dye material;
wherein upon melting the solder paste undergoes a color change from a colored state to a colorless metallic state and the melted solder paste fluoresces under black light.

11. The lead-free solder paste of Claim 10, wherein the solder powder comprises at least about 85 weight percent tin.

12. The lead-free solder paste of Claim 10 or 11, wherein the rosin tackifying material comprises a hydrogenated rosin.

13. The lead-free solder paste of Claim 10, 11 or 12, wherein the flux medium further comprises a surfactant.

14. The lead-free solder paste of Claim 13, wherein the surfactant is selected from the group consisting of ethoxylated amines, alkanolamines, ethoxylated alcohols and combinations thereof.

15. A lead-free solder paste comprising:
about 86 to about 91 composition weight percent of a solder powder including tin, silver and copper;
about 9 to about 14 composition weight percent of a flux medium, the flux medium including:
about 45 to about 50 weight percent hydrogenated rosin;
about 0.5 to about 15 composition weight percent organic acid;
about 2 to about 6 weight percent rheological modifier;
about 1 to about 15 weight percent surfactant;
about 0.2 to about 4 weight percent of at least one green dye material; and
about 0.01 to about 4 weight percent of at least one fluorescent dye material;
wherein upon melting the solder paste undergoes a color change from a colored state to a colorless metallic state and the melted solder paste fluoresces under black light.

16. The lead-free solder paste of Claim 15, wherein the solder powder comprises:
about 85 to about 99 weight percent tin;
about 2 to about 6 weight percent silver; and
about 0.1 to about 2 weight percent copper.

17. The lead-free solder paste of Claim 15 or 16, wherein the flux medium further comprises a plasticizer.

18. The-lead free solder paste of Claim 17, wherein the flux medium comprises about 1 to about 30 weight percent plasticizer.

19. The-lead free solder paste of any of Claims 15 to 18, wherein the flux medium further comprises about 10 to about 60 composition weight percent solvent.

20. The lead-free solder paste of Claim 19, wherein the solvent comprises glycol ether.
